(19) Europäisches Patentamt
European Patent Office
Office européen des brevets

(11) **EP 4 604 422 A1**

(12) **EUROPEAN PATENT APPLICATION**
published in accordance with Art. 153(4) EPC

(43) Date of publication:
**20.08.2025 Bulletin 2025/34**

(21) Application number: 23912395.3

(22) Date of filing: **20.03.2023**

(51) International Patent Classification (IPC):
*H04B 10/50* (2013.01)     *H01S 5/227* (2006.01)
*G02F 1/015* (2006.01)

(52) Cooperative Patent Classification (CPC):
**G02F 1/015; H01S 5/227; H04B 10/50**

(86) International application number:
**PCT/KR2023/003638**

(87) International publication number:
**WO 2024/143706 (04.07.2024 Gazette 2024/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.12.2022 KR 20220186175
17.03.2023 KR 20230035078**

(71) Applicant: **Phovel Co. Ltd.
Daejeon 34302 (KR)**

(72) Inventor: **KIM, Jeong Soo
Sejong 30056 (KR)**

(74) Representative: **von Bülow & Tamada
Rotbuchenstraße 6
81547 München (DE)**

(54) **METHOD FOR DRIVING ELECTRO-ABSORPTION MODULATOR OPERATING IN BURST MODE**

(57) The present disclosure relates to a method for driving an electro-absorption modulator operating in a burst mode. In the method for driving an electro-absorption modulator operating in a burst mode according to the present disclosure, the magnitude of DC voltage and AC voltage for driving the electro-absorption modulator is functionally reduced according to the elapse of time from the time at which laser light is injected into the electro-absorption modulator so that light absorption begins, and thus offset light absorption characteristics due to changes in temperature of the electro-absorption modulator area can be offset.

[FIG. 5]

Material Absorption (at various temperature)

EP 4 604 422 A1

**Description**

[Technical Field]

The present disclosure relates to a method for driving a modulator, and more particularly, to a method for driving an electro-absorption modulator operating in a burst mode.

[Background Art]

A light-emitting element currently used in high-speed optical communications is used in the form of a modulator-integrated semiconductor laser. In the modulator-integrated semiconductor laser (electro- absorption modulator integrated DFB-LD: EML), the distributed feed back-laser diode (DFB-LD) operates continuously, and an optical modulator is installed in an optical output part of the DFB-LD to generate a modulation signal using the optical modulator.

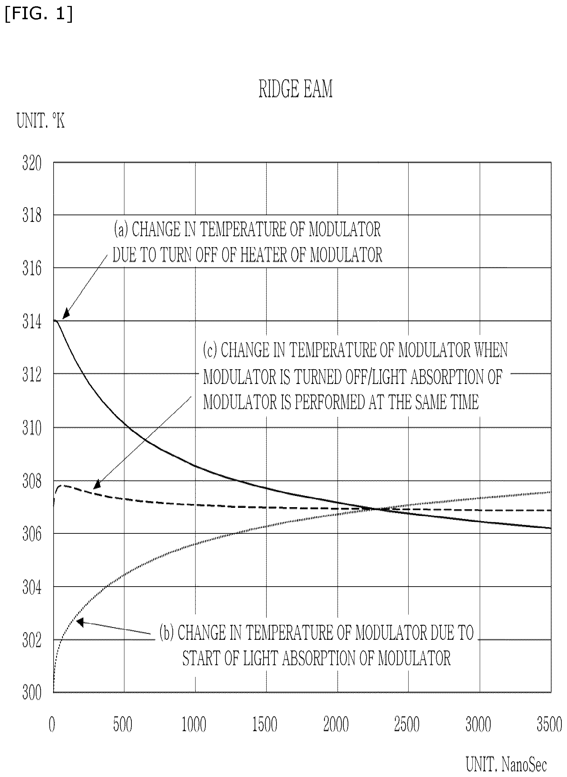

The operating characteristics of this optical modulator are as illustrated in FIG. 1.

An absorption spectrum curve according to a wavelength when a reverse voltage is not applied to the modulator shifts to a long wavelength as the absorption spectrum curve decreases when the reverse voltage is applied to the modulator. In FIG. 1, the modulator has a low absorption rate of B1 when an electric field E=0 V/cm for a light source of wavelength B fed into the modulator, and then, when a voltage of 5.4E4 V/cm is applied to the modulator, the absorption spectrum of the modulator changes to have a high absorption rate of B2, and the intensity of light passing through the modulator changes due to the difference in the absorption rates of B1 and B2. An element in which the intensity of light passing through the modulator is determined by the magnitude of the reverse voltage applied to the modulator is called an electro-absorption modulator.

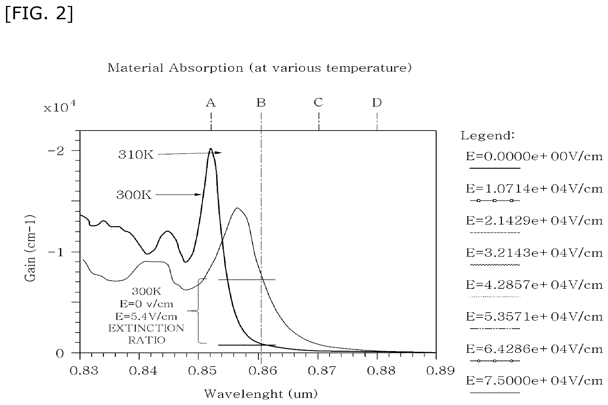

Depending on a band gap of the modulator itself and a wavelength of incoming light, even with the same modulator, the modulator operation may occur at wavelengths C in FIG. 1 and D in FIG. 1. Therefore, a well-controlled constant relationship is required between the band gap of the modulator itself and the incoming wavelength. FIG. 2 illustrates a case where the absorption spectrum of the modulator itself is measured at 300K temperature, and is a diagram illustrating the change in the absorption spectrum when a voltage is applied to the modulator maintained at 300K. However, all materials change their temperature when they absorb energy, which varies depending on the amount of energy absorbed and the heat dissipation of the materials. The semiconductor material used as the absorbing material in the modulator changes its band gap depending on the temperature, and the absorption spectrum shifts according to the electric field from the wavelength of this changed band gap. This is illustrated in FIG. 2.

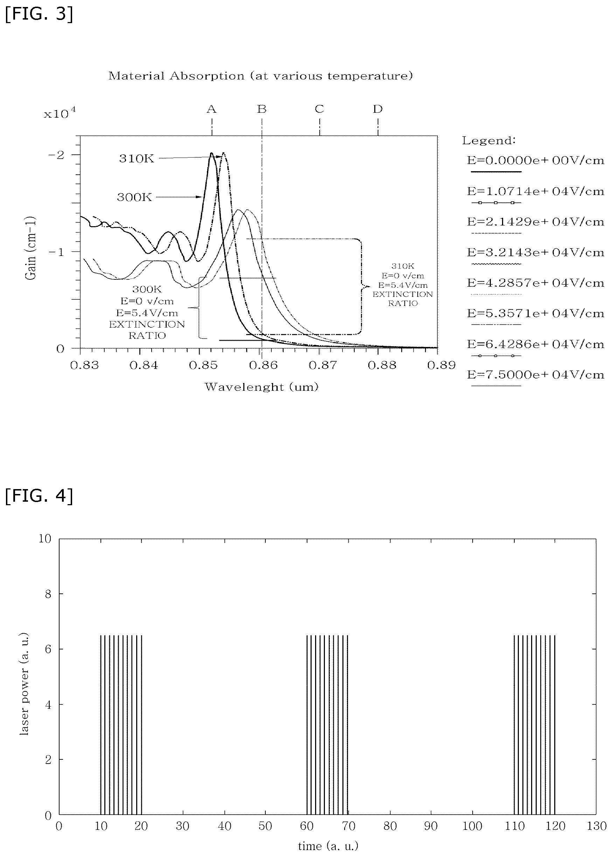

In FIG. 3, a blue absorption spectrum curve is the absorption spectrum curve according to temperature when no voltage is applied, and a yellow color is the absorption spectrum curve that shifts according to the voltage at each temperature. Therefore, in order to obtain the intensity of light passing through the modulator and the exact extinction ratio (the ratio of the signal intensities of the "1" signal and the "0" signal), the temperature of the modulator and the applied voltage must be precisely controlled. That is, in FIG. 2, the extinction ratio when a zero voltage (E = 0 V/cm) and E = 5.4E4 V/cm are applied to the input light wavelength of "B" at a temperature of 300 K will be different from the extinction ratio when zero voltage (E = 0 V/cm) and E = 5.4E4 V/cm are applied to the same input light wavelength at a temperature of 310 K of the modulator, and the average optical output will also change.

The optical signal generated by the modulator, i.e., "1" and "0" signals, is transmitted through the optical fiber, and an optical receiver extracts the "1" and "0" signals using the statistical power and signal extinction ratio of the "1" and "0" signals. Therefore, when the modulator is driven using the same voltage from a time at which the modulator operates, the temperature of the modulator changes over time, and accordingly, the average power and extinction ratio of the signal generated from the modulator change, which acts as an error in the receiver.

The conventional electro-absorption modulator operates in a continuous wave (CW) (continuous operation), so that after the initial time has passed, the temperature of the modulator stabilizes and no additional change in temperature occurs in the modulator region. On the other hand, in the modulator operating in burst mode as illustrated in FIG. 4, the operation changes between a time when light is not applied to the modulator and a time when light is applied to the modulator to form a modulation signal, so the temperature of the optical absorption region of the modulator continuously changes according to the burst operation, and accordingly, the signal transmission using the modulator operating in the burst mode becomes difficult.

[Related Art Document]

[Patent Document]

(Patent Document 1) Korean Patent Publication No. 10-0362060 (published on November 11, 2002)

[Disclosure]

[Technical Problem]

The present disclosure has been proposed to solve the problems occurring in the conventional electro-absorption modulator operating in a burst mode, and an object of the present disclosure provides a method for driving an electro-absorption modulator which can solve the problem that, in an electro-absorption modulator operating in a burst mode, the intensity of a light source entering a modulator changes depending on an operation of the light source, and accordingly, the temperature of the modulator changes depending on the intensity of light absorbed by the modulator, and under modulator driving conditions that do not take into account the change in temperature of the modulator, the average intensity and extinction ratio of light passing through the modulator change over time, making it difficult to distinguish signals at an optical receiver.

[Technical Solution]

According to an exemplary embodiment, provided is a method for driving an electro-absorption modulator operating in a burst mode, in which magnitudes of DC voltage and AC voltage for driving the electro-absorption modulator are functionally reduced according to an elapse of time from a time at which laser light is injected into the electro-absorption modulator so that light absorption begins.

A function for reducing the magnitudes of the DC voltage and AC voltage over time may be preset and recorded in a memory.

A laser diode as a light source may be manufactured integrally in an optical input part of the electro-absorption modulator and operate.

An optical amplifier may be manufactured integrally in an optical output part of the electro-absorption modulator and operate.

The electro-absorption modulator may be a ridge type modulator having a deep ridge structure.

The electro-absorption modulator may produce a "0" signal with a DC voltage +1/2 modulation voltage and a "1" signal with a DC voltage -1/2 modulation voltage, or apply a modulation voltage of a process equivalent thereto, and a decreasing function of the DC voltage and the modulation voltage after the electro-absorption modulator operates may decrease exponentially over time.

The electro-absorption modulator may produce a "0" signal with a DC voltage +1/2 modulation voltage and a "1" signal with a DC voltage -1/2 modulation voltage, or apply a modulation voltage of a process equivalent thereto, and a decreasing function of the DC voltage and the modulation voltage after the electro-absorption modulator operates may be a function having a characteristic of offsetting a temperature increase of the electro-absorption modulator over time.

The laser diode may be a reverse mesa structure having a heater mounted on an upper portion thereof.

The electro-absorption modulator may be a reverse mesa structure having a heater mounted on an upper portion thereof.

The heater mounted on the upper portion of the electro-absorption modulator may be driven to offset a change in temperature due to light absorption of the modulator operating in a burst mode.

The heater mounted on the upper portion of the electro-absorption modulator may be mounted on an upper electrode of the modulator, separated by an insulating film.

The heater mounted on the upper portion of the electro-absorption modulator may be connected to an external electrode in a form of an air bridge.

[Advantageous Effects]

According to the method for driving the electro-absorption modulator operating in a burst mode of the present disclosure, it is possible to suppress the change in temperature due to the light absorption of the modulator operating in the burst mode and the change in optical output and extinction ratio according to the change in temperature, thereby facilitating the signal discrimination at the optical receiver.

[BRIEF DESCRIPTION OF THE DRAWINGS]

FIG. 1 is a graph illustrating a change in absorption spectrum according to a voltage applied to an electro-absorption modulator.

FIG. 2 is an operating principle according to a driving voltage of the modulator.

FIG. 3 illustrates an example illustrating that an extinction ratio of a modulation signal changes according to the change in temperature of the modulator when the modulator is driven with a constant driving voltage regardless of a temperature of the modulator.

FIG. 4 illustrates an example of a burst mode operation of the modulator.

FIG. 5 illustrates an example of optical output characteristics of the modulator that is modulated by changing a driving voltage of the modulator to offset a change in temperature of an absorption region of the modulator according to the present disclosure.

FIG. 6 illustrates an example of the change in temperature according to an optical absorption time of the modulator region operating in the burst mode according to the present disclosure.

FIG. 7 is another example of the change in temperature of the modulator region according to the optical absorption from a time at which the modulator operates according to the present disclosure.

FIG. 8 illustrates an example of a light source having a reverse mesa ridge structure in which a heater is mounted according to the present disclosure.

FIG. 9 illustrates an example of a modulator with a reverse mesh ridge structure having a deep ridge structure in which a heater is mounted according to the present disclosure.

FIG. 10 illustrates an example of a heater driving method in the modulator in which the heater is mounted according to the present disclosure.

FIG. 11 illustrates an example of a change in temperature of the modulator when the burst on starts in the modulator according to the present disclosure and light absorption occurs, and at the same time, the heater stops and heat generation by the heater disappears.

[Best Mode]

Hereinafter, unlimited preferred embodiments of the present disclosure will be described in detail with reference to the accompanying drawings.

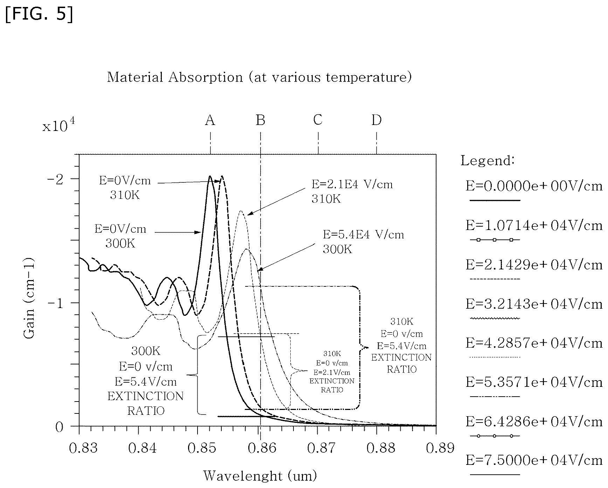

FIG. 5 illustrates an example of optical output characteristics of the modulator that is modulated by changing a driving voltage of the modulator to offset a change in temperature of an absorption region of the modulator according to the present disclosure.

FIG. 5 illustrates an extinction ratio under the driving voltage conditions of E=0 v/cm and E=5.4 V/cm, which are indicated in blue at a temperature of 300 K. A blue solid line is an absorption spectrum for 300 K and E=0 v/cm. In this case, an absorption of a "B" wavelength hardly occurs. A blue dotted line illustrates an absorption when an electric field of 5.4E4 V/cm is applied, from which an initial extinction ratio is determined. However, when this modulator starts absorbing light and the temperature of the modulator increases to 310 K, if the same electric field of 0 V/cm and 5.4E4 V/cm is applied, the extinction ratio becomes very large. Therefore, when the electric field is maintained the same, a change in temperature of a modulator region over time and a change in the extinction ratio accordingly are unavoidable.

In FIG. 5, when the temperature of the modulator is increased to 310K, if the electric field of the modulator changes to 0 V/cm and 2.1E4 V/cm, it can be seen that an extinction ratio similar to the extinction ratio that may be obtained at 300K, 0 V/cm, and 5.4E4 V/cm may be obtained.

As illustrated in FIG. 5, by changing a driving voltage by a method for minimizing a change in an extinction ratio due to the change in temperature according to the start of the burst mode and a change in an absorption curve according to the change in temperature of the modulator, the change in the extinction ratio may be minimized at the beginning and end of the burst.

Although the present disclosure has been described using the electric field, since an electric field direction length of the actually manufactured modulator is fixed, the change in the electric field may be implemented by the change in the voltage applied to the modulator. Typically, the voltage of the modulator is given as a sum of a DC voltage and an AC modulation voltage corresponding to "1" and "0" signals, so the change in the extinction ratio due to the change in the modulator temperature may be offset by the change in the DC voltage and the modulation voltage due to the change in the modulator temperature.

"1" signal voltage = DC voltage - 1/2 AC modulation voltage

"0" signal voltage = DC voltage + 1/2 AC modulation voltage

However, the modulation voltage does not necessarily have to be implemented in this way, and various methods are possible for applying voltages according to the "1" and "0" signals.

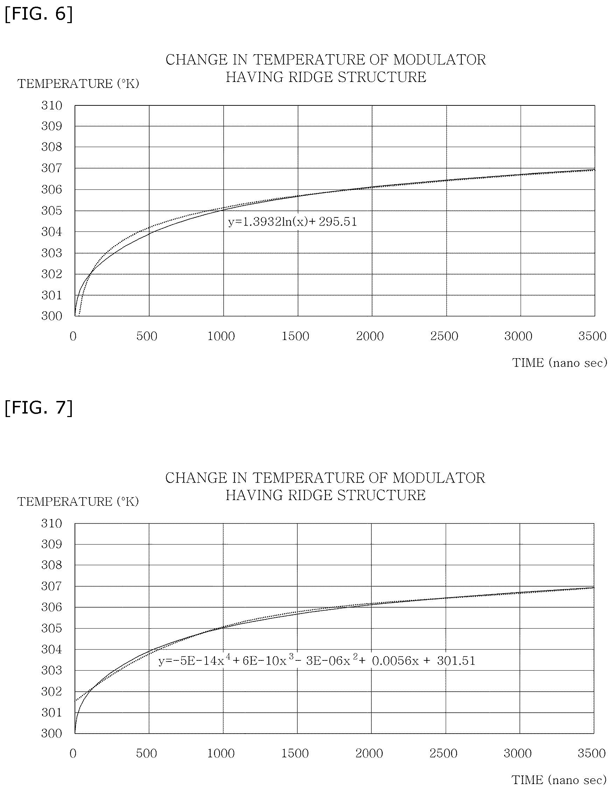

Basically, the change in temperature of the modulator leads to the change in the absorption spectrum. Accordingly, in order to obtain the change in the modulation voltage to offset the change in the modulation characteristics of the modulator, the change in temperature of the modulator according to the operating time of the modulator should first be measured. The change in temperature from the start of the operation of the modulator varies depending on the structure of the modulator and the intensity of light entering the modulator, and FIGS. 6 and 7 illustrate examples of the change in temperature from a time at which the modulator operates.

In FIGS. 6 and 7, the change in temperature of the modulator may be simulated as a change in temperature close to an exponential function and the fourth power of a high-order term. Since a wavelength shift of the modulator changes almost linearly with temperature, as illustrated in the examples in FIGS. 6 and 7, the change in temperature of the modulator is simulated first and the change in spectrum of the modulator is inferred accordingly, so the DC voltage and AC modulation voltage to offset the change in characteristics such as the extinction ratio of the modulator may be obtained as a function of time. There may be various changes in FIGS. 6 and 7, but the important point is that the changed DC voltage and AC modulation voltage to offset the change in temperature of the modulator over time and the change in characteristics of the modulator at each time are applied to the modulator.

A method can be used in which the changes in the DC voltage and AC modulation voltage of the modulator are substituted into a function from a time at which a burst signal starts and the modulation voltage of the actual modulator is adjusted from this function, or a method may be used in which a look-up table over time is stored in memory and the DC voltage and AC modulation voltage for driving the modulator are read from the memory to drive the modulator.

In order to manufacture a modulator that operates in a burst mode, a light source that operates in the burst mode is required, and the modulator and the light source are usually manufactured to be integrated. The light source is composed of a DFB-LD or a distributed Bragg reflector-laser diode (DBR-LD), and the wavelength of the light source itself changes depending on the burst mode operation of the light source. Therefore, the change in the wavelength of the light source itself should be suppressed, and it is preferable to embed an electric heater in one side or an upper portion of the DFB-LD. In order to facilitate the embedding of this heater, it is appropriate that the light source structure of the DFB-LD is a ridge structure having a reverse mesa structure.

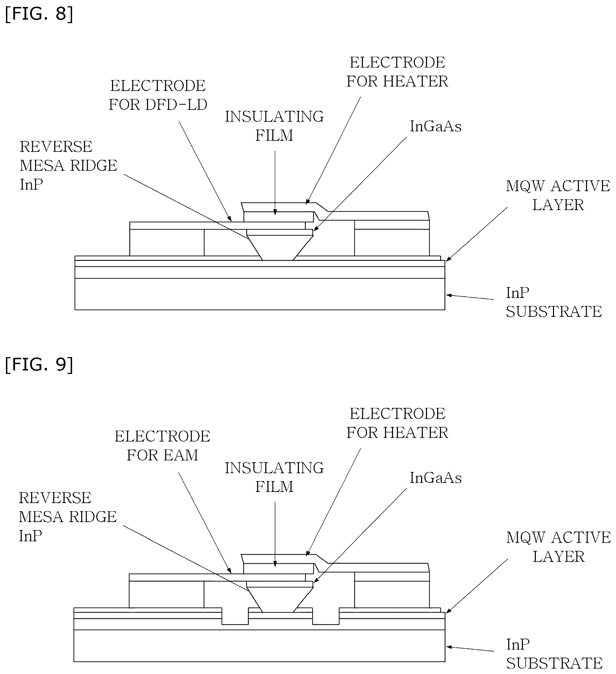

FIG. 8 illustrates an example of a light source having a reverse mesa ridge structure equipped with a heater according to an embodiment of the present disclosure. A current for operating the light source is injected into an electrode (p-type electrode) for the DFB-LD of FIG. 8, and the heater is arranged in the upper portion of the electrode for the DFB-LD and is driven complementarily with the current for operating the light source to offset the change in temperature in the laser diode region due to the burst mode operation of the laser diode. That is, the heater is mounted in the upper portion of the DFB-LD light source, and the structure of the DBB-LD light source has a reverse mesa ridge structure that makes it easy to mount the heater in the upper portion. The reverse mesa ridge means a structure in which an upper portion of a clad layer composed of p-InP/P-InGaAs layers is wider than a lower portion. In FIG. 8, since the electrode for operating the light source is arranged in the upper portion of the mesa, it is preferable that the heater is manufactured by being separated by an insulating film and overlapping on the upper electrode for driving the light source.

The characteristics to be improved in the present disclosure are that the period in which the modulator performs light absorption and modulation transmission appears in the form of a burst, and there is no light absorption in the modulator during a period other than a burst on time, so the modulator is cooled, and the light absorption begins during the burst on time and the temperature of the modulator rises. As a result, the light absorption characteristics also change over time. Therefore, the method described above uses a change in driving voltage of the modulator to offset the change in temperature of the modulator to maintain the characteristics of the light absorption of the modulator constant, while the method for mounting the heater on the modulator may be used as the method for maintaining the characteristics of the light absorption of the optical modulator constant after the burst on.

FIG. 9 illustrates an example of a modulator of a reverse mesh ridge structure having a deep ridge structure in which the heater is mounted according to the present disclosure.

In FIG. 9, two grooves are formed on both sides of the modulator having the reverse mesa ridge structure on the substrate, these grooves form a deep ridge structure, and the deep ridge structure concentrates the electric field of the modulator on the active region, thereby improving the characteristics of the modulator. FIG. 9 illustrates a method for mounting a heater in a modulator region to keep the heater off while the modulator performs the role of light absorption/light modulation/light transmission, and operate the heater to prevent cooling when the modulator does not perform the role of light absorption/light modulation/light transmission, thereby always maintaining the modulator at a constant temperature regardless of whether the modulator is in operation and preventing the change in temperature due to the light absorption of the modulator and the change in optical modulation characteristics due to the change in temperature.

In FIG. 9, the heater is mounted on the upper portion of the modulator, and it is preferable that the structure of the modulator has a structure of the reverse mesa ridge so that the heater may be easily mounted on the upper portion. The reverse mesa ridge refers to a structure in which an upper portion of a clad layer composed of the p-InP/P-InGaAs layers is wider than a lower portion. A lower width of the ridge has 1 to 2 $\mu$m so that light has a single transverse mode, while an upper width of the ridge may have a width of at least 0.5 $\mu$m or more. It is more preferable that a cross-section of the ridge is a (111) plane. In this case, the upper width of the ridge may be 2 to 3 $\mu$m wider than the lower width of the ridge, making it easy to additionally mount the heater.

In FIG. 9, it is preferable for the high-speed modulator to minimize capacitance, and accordingly, it is preferable for the heater electrode to be connected to the external electrode in the form of the air bridge to minimize parasitic capacitance. This electrode in the form of the air bridge is manufactured in the form in which the part where the electrode metal is connected to the pad is floating in the air, which minimizes the parasitic capacitance generated at the connection part of the heater pad, facilitating the high-speed operation of the device. In addition, since the electrode for operating the modulator is arranged in the upper portion of the mesa, it is preferable that the heater is manufactured by being separated by the insulating film and overlapping on the upper electrode for driving the modulator. In FIG. 9, the insulating film, etc., for protecting InP is not illustrated for the sake of a brief description, but a surface protection layer, such as an insulating film of a general modulator structure, may be added.

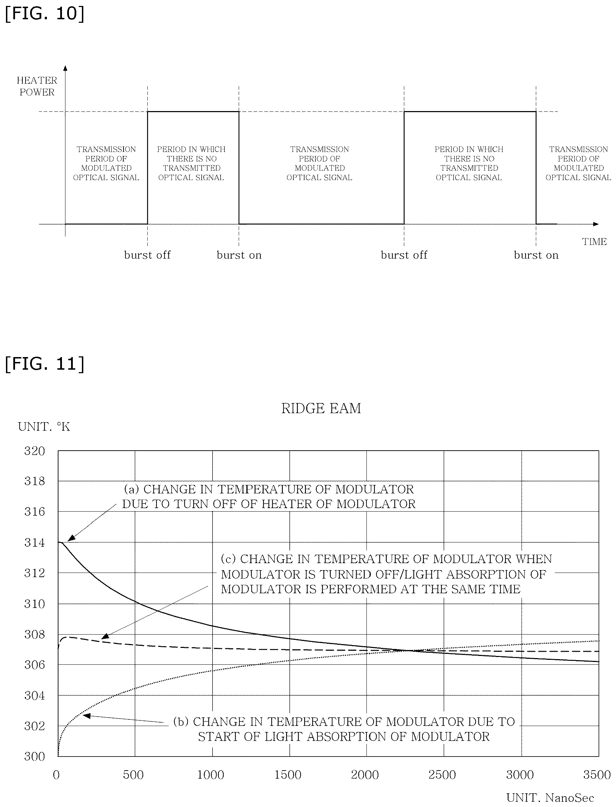

FIG. 10 illustrates a method of driving a heater in a modulator equipped with the heater. The heater is turned off during a burst on period in which the light absorption/light modulation/light transmission occurs in the modulator, and the heater is turned on during a burst-off period in which no light is supplied to the modulator, thereby replacing the light absorption power occurring in the modulator and maintaining the temperature of the modulator constant regardless of the burst on/off.

The change in temperature of the modulator when the burst on starts in the modulator and the light absorption occurs, and at the same time, the heater is stopped and the heat generation by the heater disappears is illustrated in FIG. 11. The temperature by the heater, which is curve a in FIG. 11, illustrates the change in temperature of the modulator over time when the heater stops generating heat when there is no light absorption, and the temperature of light absorption, which is curve b of FIG. 11, illustrates the change in temperature of the modulator when the light absorption starts in the modulator in the state in which the heater is not operating. Therefore, when these two effects occur simultaneously, the average effect of the two effects of the (a) and (b) is represented by curve (c) of FIG. 11, and as illustrated in curve (c) of FIG. 11, the temperature of the modulator is maintained constant regardless of the burst on/off, so the characteristics of the modulator may be stable.

In this way, in the present disclosure, the DC voltage and the modulation voltage driving the modulator change as a function over time, and the modulator is driven to offset the change in temperature of the modulator according to the modulator driving time, so the average intensity and extinction ratio of the output optical signal of the modulator may be maintained constant.

Meanwhile, in FIG. 9 described above, the power modulation of the heater does not need to alternate between a predetermined power and power of 0, and the purpose of the present disclosure may be achieved if the heater modulation power offsets the heat amount change due to the light absorption of the modulator.

In addition, although the light source such as the DFB-LD in FIGS. 8 and 9 has been described as having the reverse mesa ridge structure and the modulator also has the reverse mesa ridge structure, a combination of the light source such as the DBR-LD having the mesa structure and the reverse mesa modulator structure equipped with the heater is also possible.

As described above, the present disclosure is not limited to the exemplary embodiment described above, but may be variously modified and altered without departing from the spirit and scope of the present disclosure and equivalents to the following claims by those skilled in the art to which the present disclosure pertains.

## Claims

1. A method for driving an electro-absorption modulator operating in a burst mode, wherein magnitudes of DC voltage and AC voltage for driving the electro-absorption modulator are functionally reduced according to an elapse of time from a time at which laser light is injected into the electro-absorption modulator so that light absorption begins.

2. The method of claim 1, wherein a function for reducing the magnitudes of the DC voltage and AC voltage over time is preset and recorded in a memory.

3. The method of claim 1, wherein a laser diode as a light source is manufactured integrally in an optical input part of the electro-absorption modulator and operates.

4. The method of claim 1, wherein an optical amplifier is manufactured integrally in an optical output part of the electro-absorption modulator and operates.

5. The method of claim 1, wherein the electro-absorption modulator is a ridge type modulator having a deep ridge structure.

6. The method of claim 1, wherein the electro-absorption modulator produces a "0" signal of the electro-absorption modulator with a DC voltage +1/2 modulation voltage and a "1" signal of the electro-absorption modulator with a DC voltage -1/2 modulation voltage, or applies a modulation voltage of a process equivalent thereto, and
a decreasing function of the DC voltage and the modulation voltage after the electro-absorption modulator operates decreases exponentially over time.

7. The method of claim 1, wherein the electro-absorption modulator produces a "0" signal of the electro-absorption modulator with a DC voltage +1/2 modulation voltage and a "1" signal of the electro-absorption modulator with a DC voltage -1/2 modulation voltage, or applies a modulation voltage of a process equivalent thereto, and
a decreasing function of the DC voltage and the modulation voltage after the electro-absorption modulator operates is a function having a characteristic of offsetting a temperature increase of the electro-absorption modulator over time.

8. The method of claim 3, wherein the laser diode is a reverse mesa structure having a heater mounted on an upper portion thereof.

9. The method of claim 1, wherein the electro-absorption modulator is a reverse mesa structure having a heater mounted on an upper portion thereof.

10. The method of claim 9, wherein the heater mounted on the upper portion of the electro-absorption modulator is driven to offset a change in temperature due to light absorption of the modulator operating in a burst mode.

11. The method of claim 9, wherein the heater mounted on the upper portion of the electro-absorption modulator is mounted on an upper electrode of the modulator, separated by an insulating film.

12. The method of claim 9, wherein the heater mounted on the upper portion of the electro-absorption modulator is connected to an external electrode in a form of an air bridge.

[FIG. 1]

RIDGE EAM

UNIT. °K

(a) CHANGE IN TEMPERATURE OF MODULATOR
DUE TO TURN OFF OF HEATER OF MODULATOR

(c) CHANGE IN TEMPERATURE OF MODULATOR WHEN
MODULATOR IS TURNED OFF/LIGHT ABSORPTION OF
MODULATOR IS PERFORMED AT THE SAME TIME

(b) CHANGE IN TEMPERATURE OF MODULATOR DUE TO
START OF LIGHT ABSORPTION OF MODULATOR

UNIT. NanoSec

[FIG. 2]

Material Absorption (at various temperature)

[FIG. 3]

Material Absorption (at various temperature)

[FIG. 4]

[FIG. 5]

Material Absorption (at various temperature)

[FIG. 6]

CHANGE IN TEMPERATURE OF MODULATOR
HAVING RIDGE STRUCTURE

TEMPERATURE (°K)

$y = 1.3932\ln(x) + 295.51$

TIME (nano sec)

[FIG. 7]

CHANGE IN TEMPERATURE OF MODULATOR
HAVING RIDGE STRUCTURE

TEMPERATURE (°K)

$y = -5E\text{-}14x^4 + 6E\text{-}10x^3 - 3E\text{-}06x^2 + 0.0056x + 301.51$

TIME (nano sec)

[FIG. 8]

ELECTRODE
FOR HEATER

ELECTRODE
FOR DFD-LD

INSULATING
FILM

InGaAs

REVERSE
MESA RIDGE
InP

MQW ACTIVE
LAYER

InP
SUBSTRATE

[FIG. 9]

ELECTRODE
FOR HEATER

ELECTRODE
FOR EAM

INSULATING
FILM

InGaAs

REVERSE
MESA RIDGE
InP

MQW ACTIVE
LAYER

InP
SUBSTRATE

[FIG. 10]

HEATER POWER

| TRANSMISSION PERIOD OF MODULATED OPTICAL SIGNAL | PERIOD IN WHICH THERE IS NO TRANSMITTED OPTICAL SIGNAL | TRANSMISSION PERIOD OF MODULATED OPTICAL SIGNAL | PERIOD IN WHICH THERE IS NO TRANSMITTED OPTICAL SIGNAL | TRANSMISSION PERIOD OF MODULATED OPTICAL SIGNAL |

TIME

burst off          burst on          burst off          burst on

[FIG. 11]

RIDGE EAM

UNIT. °K

(a) CHANGE IN TEMPERATURE OF MODULATOR
DUE TO TURN OFF OF HEATER OF MODULATOR

(c) CHANGE IN TEMPERATURE OF MODULATOR WHEN
MODULATOR IS TURNED OFF/LIGHT ABSORPTION OF
MODULATOR IS PERFORMED AT THE SAME TIME

(b) CHANGE IN TEMPERATURE OF MODULATOR DUE TO
START OF LIGHT ABSORPTION OF MODULATOR

UNIT. NanoSec

## INTERNATIONAL SEARCH REPORT

| International application No. |
|---|
| **PCT/KR2023/003638** |

**A. CLASSIFICATION OF SUBJECT MATTER**

**H04B 10/50**(2013.01)i; **H01S 5/227**(2006.01)i; **G02F 1/015**(2006.01)i

According to International Patent Classification (IPC) or to both national classification and IPC

**B. FIELDS SEARCHED**

Minimum documentation searched (classification system followed by classification symbols)

H04B 10/50(2013.01); G02F 1/015(2006.01); H01S 5/0683(2006.01); H01S 5/0687(2006.01); H01S 5/12(2006.01); H01S 5/30(2006.01); H04B 10/079(2013.01); H04B 10/54(2013.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전계 흡수 변조기(electro absorption modulator), DC 전압(direct current voltage), AC 전압(alternating current voltage), 함수(function), 레이저(laser)

**C. DOCUMENTS CONSIDERED TO BE RELEVANT**

| Category* | Citation of document, with indication, where appropriate, of the relevant passages | Relevant to claim No. |
|---|---|---|
| Y | JP 2014-215600 A (SUMITOMO ELECTRIC IND., LTD.) 17 November 2014 (2014-11-17)<br>See paragraphs [0013], [0015]-[0016] and [0018]; and figures 1-4. | 1-12 |
| Y | KR 10-2005-0048941 A (ELECTRONICS AND TELECOMMUNICATIONS RESEARCH INSTITUTE) 25 May 2005 (2005-05-25)<br>See page 6; claim 1; and figure 8. | 1-12 |
| Y | JP 2013-211381 A (FUJITSU LTD.) 10 October 2013 (2013-10-10)<br>See paragraphs [0007]-[0009], [0023], [0037] and [0045]; and figures 1(a)-1(b), 5(i) and 18. | 3-5,8-12 |
| Y | JP 6880333 B2 (MITSUBISHI ELECTRIC CORPORATION) 02 June 2021 (2021-06-02)<br>See paragraph [0020]. | 6-7 |
| A | JP 2018-006539 A (FUJITSU OPTICAL COMPONENTS LTD.) 11 January 2018 (2018-01-11)<br>See paragraphs [0041]-[0060]; and figures 6-9. | 1-12 |

| ✔ Further documents are listed in the continuation of Box C. | ✔ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 September 2023** | **20 September 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 604 422 A1

**INTERNATIONAL SEARCH REPORT**

International application No.

**PCT/KR2023/003638**

## C. DOCUMENTS CONSIDERED TO BE RELEVANT

| Category* | Citation of document, with indication, where appropriate, of the relevant passages | Relevant to claim No. |
|---|---|---|
| L | PCT/KR2022/021428 has the same priority date as the present application(PCT/KR2023/003638), and claims 1-8 are the same as claims 1-8 of the present application, respectively. (Therefore, PCT/KR2022/021428 is related to category "L".) | 1-8 |

Form PCT/ISA/210 (second sheet) (July 2022)

16

**INTERNATIONAL SEARCH REPORT**
Information on patent family members

International application No.

**PCT/KR2023/003638**

| Patent document cited in search report | | | Publication date (day/month/year) | Patent family member(s) | | | Publication date (day/month/year) |
|---|---|---|---|---|---|---|---|
| JP | 2014-215600 | A | 17 November 2014 | None | | | |
| KR | 10-2005-0048941 | A | 25 May 2005 | US | 2005-0111502 | A1 | 26 May 2005 |
| | | | | US | 7167493 | B2 | 23 January 2007 |
| JP | 2013-211381 | A | 10 October 2013 | JP | 5974590 | B2 | 23 August 2016 |
| JP | 6880333 | B2 | 02 June 2021 | WO | 2020-039549 | A1 | 27 February 2020 |
| | | | | WO | 2020-039725 | A1 | 27 February 2020 |
| JP | 2018-006539 | A | 11 January 2018 | JP | 6717082 | B2 | 01 July 2020 |
| | | | | US | 10536217 | B2 | 14 January 2020 |
| | | | | US | 2018-0006721 | A1 | 04 January 2018 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 100362060